# EUROPÄISCHE PATENTANMELDUNG

(11) **EP 0 979 029 A2**
(43) Veröffentlichungstag der Anmeldung: **09.02.2000**
(21) Anmeldenummer: 99114915.4
(22) Anmeldetag: 30.07.1999
(51) Int. Cl.: H05K 3/18, H05K 3/02, H05K 3/24

(54) **Verfahren zur Erzeugung von Leiterplatten**

(30) Priorität: 04.08.1998 DE 19835158
(71) Anmelder: Anger, Wolfgang, 6370 Kitzbühel (AT)
(72) Erfinder: Anger, Wolfgang, 6370 Kitzbühel (AT)
(74) Vertreter: Riebling, Peter, Dr.-Ing.

(57) **Zusammenfassung**

Bei der vorliegenden Erfindung handelt es sich um ein Verfahren zur Erzeugung einer Leiterplatte. Die Bohrungen werden dabei vor der Beschichtung des Substrates mit einer metallorganischen Schicht der leitfähigen Schicht angebracht, auf die anschließend die leitfähige Schicht in der Form der gewünschten Leiterbahnen aufgetragen wird.

## Beschreibung

Gegenstand der Erfindung ist ein Verfahren zur Erzeugung von Leiterplatten und eine nach dem Verfahren hergestellte Leiterplatte. Verfahren zur Erzeugung von Leiterplatten sind in vielfältigen Ausführungsformen bekannt geworden. Das Anwendungsgebiet der Erfindung bezieht sich insbesondere auf Multilayer-Leiterplatten, flexible Schaltungen, die Herstellung von Chips und hybriden Schaltungen. Der im folgenden genannte Begriff 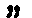 Leiterplatte" umfasst also alle vorgenannten Gegenstände.

Mit der EP 349 882 B1 ist ein Verfahren bekanntgeworden, mit dem eine Leiterplatte auf relativ schwierige Art hergestellt werden soll. Es wird nämlich vor ein Substrat ein UV-durchlässiger Träger angeordnet, dessen Rückseite mit einem metallorganischen Film beschichtet ist.

Wird nun der Träger von seiner Vorderseite her mit einem UV-Laser bestrahlt, so durchdringen die Laserpulse den Träger, und treffen auf den auf der Rückseite des Trägers angeordneten metallorganischen Film. Dort werden durch den Laserpuls einzelne Moleküle aus dem metallorganischen Film herausgelöst und über eine gewisse Luftstrecke hinweg auf das die Luftstrecke auf der gegenüberliegenden Seite begrenzende Substrat aufgetragen. Es handelt sich also um eine indirekte Beschichtung eines Substrates über einen Träger und einen auf der Rückseite des Trägers angeordneten metallorganischen Film. Dieses Verfahren ist aufwendig und entsprechend teuer.

Der Erfindung liegt deshalb die Aufgabe zugrunde, ein Verfahren und eine Vorrichtung der eingangs genannten Art so weiterzubilden, daß die Beschichtung eines Substrates wesentlich einfacher, schneller und kostengünstiger vollzogen werden kann.

Zur Lösung der gestellten Aufgabe ist die Erfindung durch folgende Verfahrensschritte gekennzeichnet:
1. Eine unbeschichtete Leiterplatte wird gebohrt.
2. Die so vorbereitete Leiterplatte wird mit einer metallorganischen oder metallischen oder Graphitverbindung beschichtet.
3. Auf die beschichteten Flächen der Leiterplatte wird eine Maske aufgelegt, welche teilweise lichtdurchlässig und teilweise nicht lichtdurchlässig ist.
4. Die Maske wird belichtet.
5. Die Maske wird entfernt und die unbelichteten Schichten der beschichteten Leiterplatte werden z. B. durch Auswaschen entfernt.
6. Auf die verbleibenden ausgehärteten Schichten, auch im Bereich der Löcher wird eine Leitmetallschicht aufgetragen.

Damit ist die Leiterplatte fertiggestellt. Es handelt sich also um ein sehr einfaches, kostengünstiges und auch schnelles Verfahren, weil eine indirekte Beschichtung der Leiterplatte, sowie sie mit der DE 40 34 834 C2 beschrieben wird, entfällt.

Als Werkzeug zum Bohren der Leiterplatte wird bevorzugt ein Laser verwendet, der sowohl Sacklöcher als auch Durchgangsbohrungen vornehmen kann. Statt eines derartigen Lasers kann natürlich auch ein mechanischer Bohrer verwendet werden.

Als metallorganische Verbindung können Metallacetate , Metallacetylacetonate und Metallformiate verwendet werden. Darunter fallen vor allem Palladiumverbindungen, insbesondere eine Beschichtung mit einer Palladiumacetatlösung durch Tauchen der Substratoberfläche in diese Lösung oder auch durch Aufspatteren, Sprühen oder durch galvanische Anlagerung dieser Schicht.

Diese Schicht kann auch durch Auftragen einer Palladiumchloridlösung gebildet werden.

Ebenso besteht die Möglichkeit, Cyclopentadienyl-palladium-alyl, das in Pulverform vorliegt, in Alkohol oder Wasser zu lösen und auf dem Substrat aufzutragen.

Die Verwendung von pulverförmigen Cyclopentadienyl-palladiumchlorid, das zur Ausbildung einer Lösung ebenfalls in Alkohol oder Wasser gelöst wird, ist ebenfalls möglich.

Weitere mögliche metallorganische Verbindungen sind Palladiumacetylacetonat, Kobaltacetat, Nickelacetat, Kupferformiat und Silberneodecanat.

In einer anderen Ausgestaldung der Erfindung ist es vorgesehen, daß anstatt der vorher angegebenen metallorganischen Verbindungen auch metallische Verbindungen oder Graphit-Verbindungen verwendet werden.

Bei dieser weiteren Ausführungsform ist es vorgesehen, daß Kupfer in Partikel- oder Pulverform bzw. Graphit in Pulver- oder Partikelform oder auch beide Partikelformen (Kupfer und Graphit) zusammen in einen chemischen Film gebunden werden, der Teil einer Photoresist-Beschichtung ist.

In eine Photoresist-Beschichtung werden also Kupfer und/oder Graphit-Partikel eingelagert und dort fixiert.

Anstatt einer Photoresist-Beschichtung können auch lichtempfindliche flüssige Beschichtungen verwendet werden, in die gleichfalls die vorher erwähnten metallischen Partikel und/oder Graphit-.Partikel gebunden sind.

Hieraus wird deutlich, daß neben der Beschichtung mittels eines metallorganischen Film auch eine Beschichtung mittels der vorher beschriebenen Partikel möglich ist.

Nachdem diese Partikel in der Photoresistschicht gebunden sind, erfolgt durch die Belichtung der Photoresistschicht mit Hilfe einer Belichtungsmaske eine Aushärtung der belichteten Schichten, während die unbelichteten Schichten nicht ausgehärtet werden.

Hieraus ergibt sich, daß im Bereich der belichteten Schichten das Kuststoffmaterial mit den dort angeordneten Kupfer und/oder Graphit-Partikeln verbleibt, während die unterbelichteten Schichten in einem chemischen Abtragungsprozess später abgewaschen werden. Es verbleiben dann nur noch die Kuststoffschichten mit eingelagerten Partikeln in Form von Leiterbahnen auf dem Substrat.

Bezüglich der Weiterverarbeitung der metallorganischen Verbindungen wird wie folgt vorgegangen:

Die Lösungen werden so dick auf das Substrat aufgetragen, daß sich eine metallische Schicht in eine Dicke von zwischen 5 bis 1000 nm ergibt.

Als Maske wird bevorzugt ein lichtundurchlässiges Material bevorzugt, wobei der Begriff sich auf 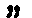 licht" sowohl das sichtbare Licht als auch das UV oder das Infrarot-Licht betrifft.

Bevorzugt wird eine UV-undurchlässige Maske verwendet, die gegen UV-Strahlen dicht ist.

Es erfolgt nämlich eine Belichtung dieser UV-dichten Maske mittels UV-Licht, wobei Wellenlängen von bevorzugt 172 nm, 222nm oder 308 nm verwendet werden.

Eine derartige Belichtung erfolgt bevorzugt mittels eines Excimer-Lasers mit Energiedichten von 10 mJ/cm² bis 1 mJ/cm².

Es kann aber auch ein YAG-Laser mit einer Wellenlänge von z.B. 532 nm verwendet werden.

Zum Belichtungsvorgang ist folgendes festzuhalten. Durch die Belichtung der UV-dichten Maske werden nun die darunterliegenden metallorganischen Schichten belichtet, die dadurch aushärten und sich fest mit der Oberfläche des Substrates verbinden. Eine Belichtung der metall-organischen Schichten kann ein- oder beidseitig erfolgen. Wichtig ist, daß die vorherige Beschichtung mit der besagten metallorganischen Schicht auch im Bereich der Durchkontaktierungen und auch der Sacklöcher erfolgte.

Aufgrund der Belichtung -auch im Bereich der Durchkontaktierungen-kommt es damit auch zu einer Aushärtung der metallischen Schicht im Bereich dieser Durchkontaktierungen.

Es wird nun die Maske entfernt und die von der Maske abgedeckten Bereiche der metallorganischen Schicht werden entfernt. Eine Entfernung kann entweder durch bloßes Auswaschen erfolgen; es können aber auch Lösechemikalien verwendet werden.

Es verbleiben dann nur noch die belichteten metallorganischen bahnenförmigen Schichtaufbauten auf dem Substrat. Ebenso verbleiben natürlich auch die Beschichtungen der Durchkontaktierungen und der Sacklöcher.

Im letzen Verfahrensschritt wird nun die so hergestellte Leiterplatte galvanisch beschichtet, wobei durch stromlosen galvanischen Auftrag Leitmetallschichten auf die vorher freigelegten metallorganischen Bahnen aufgebracht werden. Diese Bahnen werden also vollständig von der Leitmetallschicht umhüllt und bilden die späteren Leiterbahnen der Leiterplatte.
Selbstverständlich werden die vorher genannten Verfahrenschritte von beiden Seiten her ausgeführt, um eine beidseitig beschichtete Leiterplatte zu erhalten.

Es ist nicht eigens erwähnt worden, daß noch Zwischenverfahrensschritte vorgenommen werden können wie z.B. daß am Schluß mit Heißluft getrocknet wird oder daß das Auswaschen der nicht ausgehärteten metallorganischen Schichten ebenfalls mit einem Trocknungsvorgang beendet wird.

Die vorliegenden Verfahrensschritte sind auf sämtliche Substrate anwendbar; d.h. die Leiterplatte muß nicht notwendigerweise aus einem Epoxyd-Material bestehen, sondern sie kann aus beliebigen anderen Materialien bestehen, wie z.B. Silizium, Glas, Silicongummi, Keramik, aus Kunststoffen und dergl. mehr.

Der Begriff 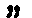 Leiterplatte" ist also weit aufzufassen; er umfaßt auch Multilayer-Platten, flexible Schaltungen und Chips.

Selbstverständlich ist das vorliegende Verfahren auch nur einseitig anwendbar, wobei dann die Rückseite des Substrates nicht behandelt wird.

Vorteil des erfindungsgemäßen Verfahrens ist, daß man nicht mehr wie bisher mit CU-beschichtete Leiterplatten behandeln muß, bei denen die Vorbeschichtung aus CU erst entfernt werden mußte, um aus CU-bestehende Leiterbahnen zu erhalten.

Eine derartige Behandlung erfolgte im Ätzverfahren, was mit der neuen Erfindung nicht mehr notwendig ist.

Wichtig bei der Erfindung ist, daß nun anstelle der CU-Schicht eine hauchdünne Schicht einer metallorganischen Verbindung oder einer Schicht aus Kupfer und/oder Graphit-Partikeln aufgetragen wird und diese mit einem UV-ExcimerLaser belichtet wird. Danach werden auf diese belichteten Schichten stromlos galvanisch die notwendigen CU-Schichten aufgebracht.

Ein Atzverfahren entfällt demgemäß.

Der Erfindungsgegenstand der vorliegenden Erfindung ergibt sich nicht nur aus dem Gegenstand der einzelnen Patentansprüche, sondern auch aus der Kombination der einzelnen Patentansprüche untereinander.

Alle in den Unterlagen, einschließlich der Zusammenfassung, offenbarten Angaben und Merkmale, insbesondere die in den Zeichnungen dargestellte räumliche Ausbildung werden als erfindungswesentlich beansprucht, soweit sie einzeln oder in Kombination gegenüber dem Stand der Technik neu sind.

Im folgenden wird die Erfindung anhand von lediglich einen Ausführungsweg darstellenden Zeichnungen näher erläutert. Hierbei gehen aus den Zeichnungen und ihrer Beschreibung weitere erfindungswesentliche Merkmale und Vorteile der Erfindung hervor.

Es zeigen:
- Figur 1:: schematisiert eine unvorbereitete Leiterplatte während des Anbringens von Bohrlöchern
- Figur 2:: Die Leiterplatte nach Figur 1 nach der Beschichtung
- Figur 3:: Die Leiterplatte nach Figur 2 während der Belichtung
- Figur 4:: Die Leiterplatte nach Figur 3 nach Entfernung der Belichtungsmaske
- Figur 5:: Die fertig hergestellte Leiterplatte
- Figur 6:: Schnitt durch einen dreilagigen Photoresist- Aufbau
- Figur 7:: Die Anordung nach Figur 6 mit Belichtung über eine Maske
- Figur 8:: Die Anordung nach Figur 7 nach erfolgter Belichtung und Entfernung der Maske
- Figur 9:: Die Anordnung nach Figur 8 nach Entfernung der Schutzschicht
- Figur 10:: Die Anordnung nach Figur 9 nach Entfernung der nicht ausgehärteten Bereiche der Resistschicht
- Figur 11:: Die weitere Beschichtung der verbliebenen Leiterbahnstrukturen der Art nach Figur 5

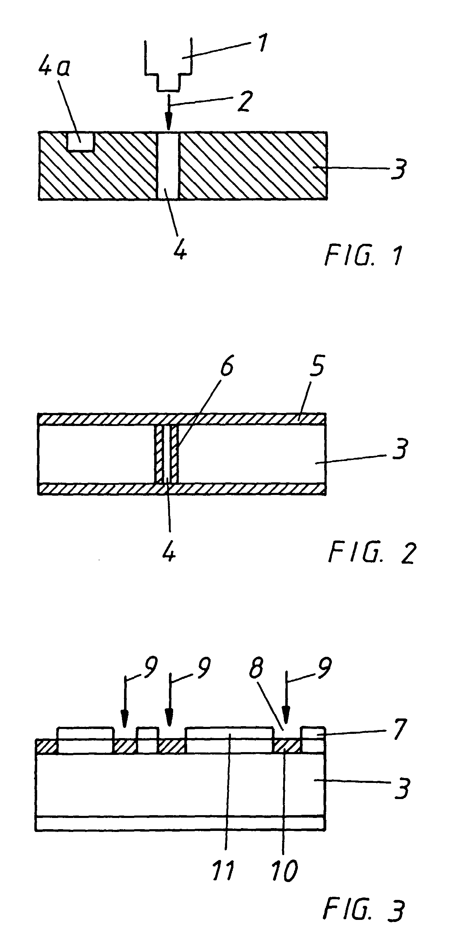

In Figur 1 wird mittels eines Laserkopfes 1 ein Laserstrahl 2 auf die unvorbereitete Leiterplatte (Substrat 3) gelenkt. Es werden hierdurch auf einfache Weise Bohrlöcher 4 erreicht, die entweder als Durchgangsloch oder als Sackloch 4a ausgebildet sein können. Es können auch sog. 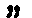 Durchsteiger" mittels Laserstrahl 2 hergestellt werden.

Vorteilhaft hierbei ist die Möglichkeit der Anbringung von Bohrlöchern auf der Platine mittels Laser. Beim Stand der Technik ist eine derartige Anbringung von Bohrlöchern mittels Laser nicht möglich, denn eine mit CU-beschichtete Leiterplatte kann nicht mittels eines Lasers gebohrt werden. Dies ist nun dank des erfindungsgemäßen Verfahrens möglich.
Die Anwendung eines Lasers zur Herstellung der genannten Bohrlöcher ist neu und wird als erfinderisch beansprucht. Bisher war nämlich eine Laserbehandlung zwecks Herstellung von Bohrlöchern bei kupferbeschichteten Leiterplatten nicht möglich, weil diese Kupferbeschichtung einen unzumutbar hohen Aufwand der Lasertechnik voraussetzte.
Nachdem nun nach der Erfindung unbeschichtete Leiterplatten Ausgangspunkt des Verfahrens sind, ist nun erstmals der Einsatz derartiger Laser zur Herstellung der Bohrlöcher unter wirtschaftlichen Bedingungen möglich.

Die Erfindung ist jedoch nicht auf die Einbringung von Bohrlöchern mittels Laser beschränkt; es können auch bekannte mechanische Bohrer verwendet werden.

In dem zweiten Verfahrensschritt wird das Substrat 3 mit einer metallorganischen Schicht 5 beschichtet. Es wurde die Art und Zusammensetzung der metallorganischen Schicht bereits schon im allgemeinen Beschreibungsteil beschrieben. Wichtig ist, daß nun auch die Bohrungen 4 und auch Sacklöcher 4a mittels dieser metallorganischen Schicht 5 ausgekleidet und beschichtet sind.

Nach Figur 3 wird auf die metallorganische Schicht 5 eine UV-dichte Maske 7 aufgelegt, die lediglich Maskenöffnungen 8 freiläßt.
Es ist der Einfachheit halber im folgenden nicht mehr dargestellt, daß die Bohrung 4 eine Auskleidung 6 aufweist, die ebenfalls entsprechend belichtet wird. Ebenso ist der Einfachheit halber nicht dargestellt, daß die Maske 7 auch beidseitig angebracht sein kann.

Die Maskenöffnungen 8 lassen Bereiche 10 frei, die von dem UV-Licht getroffen und ausgehärtet werden. Die anderen, nicht von dem UV-Licht beaufschlagten Bereiche 11 werden demgemäß nicht ausgehärtet. Das UV-Licht wird in Pfeilrichtung 9 von oben her auf die Maske 7 eingestrahlt.

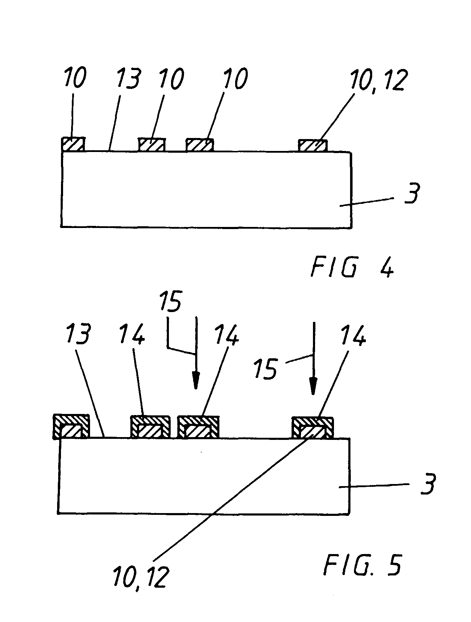

Gemäß Figur 4 wird die Maske entfernt und die nicht belichteten Bereiche 10 werden durch Auswaschen oder Ausätzen oder durch Lösen entfernt.

Es verbleiben dann die ausgehärteten Bereiche 10 übrig, die aus der besagten metallorganischen Schicht bestehen. Die dazwischenliegenden Oberflächen 13 entsprechen der unvorbereiteten Oberfläche des Substrats 3.

Es werden also Bahnstrukturen 12 aus den metallorganischen Schichten auf dem Substrat 3 gebildet.

In Figur 5 erfolgt nun eine Beschichtung dieser Bahnstrukturen 12 mittels Leitmetallschichten 14. Es wird bevorzugt stromlos oder nicht-stromlos im galvanischen Verfahren eine Leitmetallschicht 14 auf den Bahnstrukturen 12 abgeschieden, sodaß sich die Leiterbahnen 15 ergeben, die in ihrem Kern aus der metallorganischen Schicht 10 bestehen und die von den Leitmetallschichten umhüllt sind. Auf diese Weise werden also einfach Leiterbahnen 15 auf einem Substrat 3 erzeugt.

Auch hier ist es wichtig, daß die Auskleidungen 6 im Bereich der Bohrungen 4 mit den Leitmetallschichten 14 beschichtet sind, sodaß es hier zu einer vollständigen, zuverlässigen Durchkontaktierung der Leiterplatte kommt.

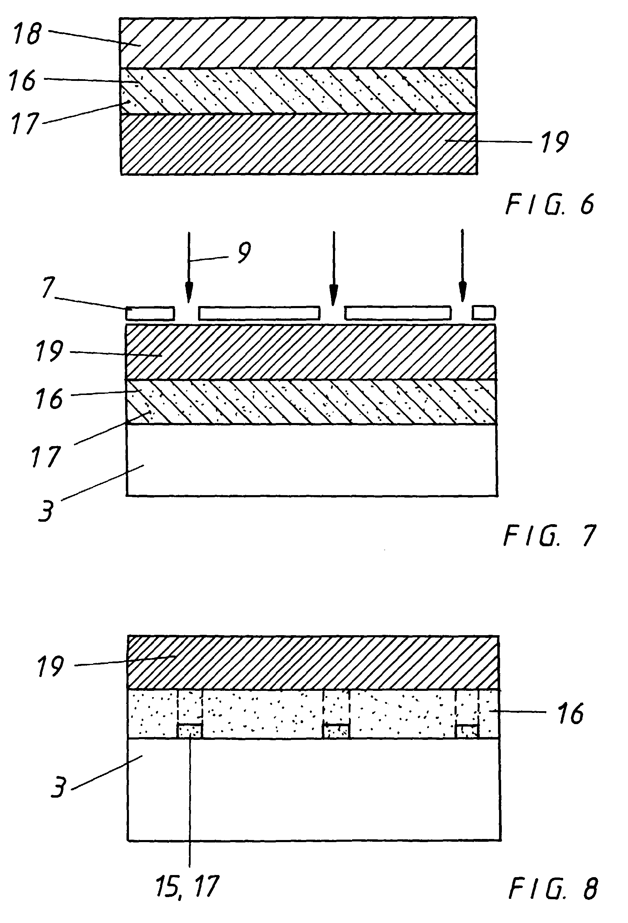

In Figur 6 ist ein dreilagiger Photo-Resistaufbau gezeigt, der im wesentlichen aus einer unteren Trägerfolie 19 besteht, welche bevorzugt aus einem Polyester-Material besteht.

Auf dieser Trägerfolie ist eine Photopoymere-Schicht 16 aufgebracht, die flüssig oder fest sein kann. In dieser Photopolymere-Schicht 16 sind nun die vorher erwähnten metallischen Partikel eingelagert, nämlich insbesondere Kupfer oder Kupfer und Graphit oder Graphit-Partikel alleine.

Jedes Partigek hat etwa eine Abmessung von 0,1 bis 5 µm und die Partikel sollen möglichst gleichmäßig in der Photopolymere-Schicht 16 verteilt sein.

Hieraus ergibt sich, daß die Erfindung nicht auf die Verwendung von Kupfer und/oder Graphit-Partikel beschränkt ist, sondern es können semtliche elektrisch leitfähigen Partikel verwendet werden, die in die Photopolymere-Schicht gleichmäßig dispergirt sind.
Diese Photopolymere-Schicht 16 ist von einer oberen Deckfolie 18 abgedeckt, die als Schutzschicht für diese Schicht 16 dient.

Zur Belichtung eines Substrates wird nun der dreilagige Aufbau nach Figur 6 gemäß Figur 7 auf das Substrat aufgelegt, wobei vorher die Deckfolie 18 entfernt wurde und die Photopolymere-Schicht 16 nun direkt auf der Oberfläche des Substrates 3 zu liegen kommt.

Auf die Trägerfolie 19 wird nun eine Maske 7 aufgelegt und in Pfeilrichtung 9 belichtet.

Aufgrund der Belichtung durch die Öffnungen der Maske 7 hindurch bilden sich ausgehärtete Leiterbahnstrukturen, die in Figur 8 angedeutet sind. Diese Leiterbahnenstrukturen 15 können sich über die gesamte Dicke der Photopolymeren-Schicht 16 erstrecken, oder auch nur teilweise sich in die Dicke dieser Photopolymere-Schicht 16 hineinstrecken, so wie dies in Figur 8 angedeutet ist.

In den ausgehärteten Bereichen sind jedenfalls auch die entsprechenden Metall-Partikel angeordnet und nun im ausgehärteten Kunststoff gebunden.

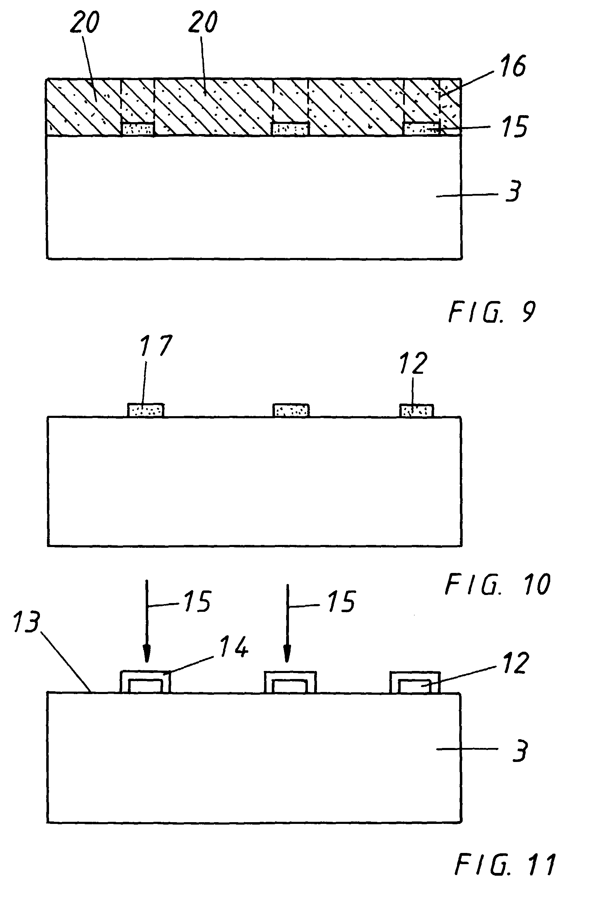

Nach Entfernung der Trägerfolie 19 gemäß Figur 9 werden nun die nicht ausgehärteten Bereiche 20 in der Photopolymere-Schicht 16 chemisch oder mechanisch entfernt, so daß nur noch die Strukturen in Form der Leiterbahnen 15 übrig bleiben.

Es ergibt sich dann der Aufbau nach Figur 10, wo erkennbar ist, daß in den Bahnstrukturen 12 kunststoffgebundenen, metallischen Partikel (Leitpartikel 17) eingelagert sind.

Auf diese Bahnstrukturen 12 wird nun gemäß der vorherigen Beschreibung entsprechend den Figuren 4 und 5 eine weitere Beschichtung in Form einer Leitmetall-Schicht 14 aufgebracht.

Mit dem erfindungsgemäßen Verfahren erfolgt insgesamt eine Kosteneinsparung von ca. 50 % gegenüber den herkömmlichen Cu-beschichteten Leiterplatten. Es wird nämlich eine Kosteneinsparung von allein 33 % gegenüber einer Cu-beschichteten Platte dadurch erreicht, daß auf die vorherige Kupferbeschichtung verzichtet werden kann, daß ein mechanisches Bohren nicht mehr notwendig ist, weil ja eine unvorbereitete Oberfläche mit Laser gebohrt werden kann und daß ein Atzvorgang jedenfalls nicht mehr notwendig ist.

### Zeichnungslegende

1. Laserkopf
2. Laserstrahl
3. Substrat
4. Bohrung
5. metallorganische Schicht
6. Auskleidung
7. Maske
8. Maskenöffnung
9. Pfeilrichtung
10.Bereich
11.Bereich
12.Bahnstruktur
13.Oberfläche
14.Leitmetallschicht
15.Leiterbahn
16. Photopolymere-Schicht
17. Leitpartikel
18. Deckfolie
19 Trägerfolie
20 Bereich

## Patentansprüche

1. Verfahren zur Erzeugung von Leiterplatten, wobei das Substrat (3) der Leiterplatte aus Epoxyd-Material, Silizium, Glas, Silicongummi, Kunststoff und der gleichen mehr bestehen kann, **dadurch gekennzeichnet,** daß das Substrat folgenden Verfahrensschritten unterzogen wird:
1. Bohren von Löchern (4) mittels einer Laserbohreinrichtung (1, 2)
2. Beschichten des Substrates (3) mit einer metallorganischen Schicht(5) oder metallischen Parkikelschicht (17)
3. Auflegen einer Belichtungsmaske (7) in der Form der gewünschten Leiterstruktur auf das Substrat (3)
4. Aushärten durch Belichten der Maske und der darunterliegenden Beschichtung (5) des Substrates
5. Entfernen der Maske und anschließendes Entfernen des nicht ausgehärteten Teils der Beschichtung (5) durch Auswaschen
6. Auftragen einer Leitmetallschicht (14) auf die Bereiche des Substrates (3) die mit der ausgehärteten metallorganischen Schicht (5) überzogen sind

2. Verfahren nach Anspruch 1 **dadurch gekennzeichnet,** daß die Löcher (4, 4a) im Substrat (3) mittels eines Lasers (1,2) erzeugt werden.

3. Verfahren nach einem der Ansprüche 1 oder 2 **dadurch gekennzeichnet,** daß die Löcher teilweise durchgängig (4) und teilweise nicht durchgängig (4a) ausgeführt werden.

4. Verfahren nach einem der vorgehenden Ansprüche **dadurch gekennzeichnet,** daß die Beschichtung des Substrates mit der metallorganischen Schicht (5) oder metallischen Partikelschicht (17) auch im Bereich der darin angebrachten Bohrungen (4, 4a) erfolgt.

5. Verfahren nach einem der vorgehenden Ansprüche **dadurch gekennzeichnet,** daß die Leitmetallschicht (14) über metallorganischen Schicht (5) oder metallischen Partikelschicht (17) galvanisch aufgetragen wird und auch im Bereich der Löcher (4,4a) stattfindet.

6. Verfahren nach einem der vorgehenden Ansprüche **dadurch gekennzeichnet,** daß die Beschichtung des Substrates (3) durch Tauchen, Sputtern, Sprühen oder galvanische Anlagerung aufgetragen wird.

7. Verfahren nach einem der vorgehenden Ansprüche **dadurch gekennzeichnet,** daß die Wellenlänge des zur Belichtung verwendeten Lichtes im UV-Bereichliegt und zwischen 172 nm und 308 nm liegt.

8. Verfahren nach einem der vorgehenden Ansprüche **dadurch gekennzeichnet,** daß die Wellenlänge des zur Belichtung verwendeten Lichtes im UV-Bereichliegt und bei 532 nm liegt.

9. Verfahren nach einem der vorgehenden Ansprüche **dadurch gekennzeichnet,** daß das Verfahren auf beiden Seiten eines Substrates (3) durchgeführt werden kann.

10. Leiterplatte hergestellt nach einem der Ansprüche 1-9**, dadurch gekennzeichnet, daß** die Bohrungen (4) durch die Leiterplatte eine metallisch leitende Auskleidung (6) aufweisen, die mit den leitfähgen Schichten sowohl auf der Vorderseite als auch auf der Rückseite verbunden sind.

11. Leiterplatte nach einem der Ansprüche 1 - 9, **dadurch gekennzeichnet,** daß der Grundaufbau der Leiterbahnstruktur (12) auf dem Substrat (3) aus einer metallorganischen Beschichtung besteht, auf der dann die leitfähigen Strukturen) z. B. aus Kupfer, aufgetragen sind.

12. Leiterplatte nach einem der Ansprüche 1 - 9, **dadurch gekennzeichnet,** daß der Grundaufbau der Leiterbahnstruktur (12) auf dem Substrat (3) aus einer Kunststoffschicht besteht, in welche metallische Partikel (17) eingelagert sind.

13. Leiterplatte nach Anspruch (12), **dadurch gekennzeichnet,** daß die metallischen Partikel aus Kupfer oder aus Graphit oder einer Mischung aus Kuper und Graphitpartikeln besteht.
